Europäisches Patentamt

European Patent Office

Office européen des brevets

(11) Publication number: **0 110 354**
**B1**

# EUROPEAN PATENT SPECIFICATION

(45) Date of publication of patent specification: **14.03.90**

(51) Int. Cl.⁵: **G 06 F 11/26**

(21) Application number: **83111846.8**

(22) Date of filing: **25.11.83**

(54) Detecting improper operation of a digital data processing apparatus.

(30) Priority: **26.11.82 US 444766**

(43) Date of publication of application:
**13.06.84 Bulletin 84/24**

(45) Publication of the grant of the patent:
**14.03.90 Bulletin 90/11**

(84) Designated Contracting States:
**DE FR GB NL**

(56) References cited:
**DE-A-2 750 475**
**US-A-2 945 915**
**US-A-3 420 991**
**US-A-4 055 754**

**IBM TECHNICAL DISCLOSURE BULLETIN, vol. 22, no. 1, June 1979, pages 210-213, New York, US; C.J. MATTES: "Random-access memory as variable delay line with fault detection"**

(73) Proprietor: **TEKTRONIX, INC.**
**Tektronix Industrial Park D/S Y3-121 4900 S.W. Griffith Drive P.O. Box 500**
**Beaverton Oregon 97077 (US)**

(72) Inventor: **Judge, John L.**
**960 N. E. Birchwood Drive**
**Hillsboro Oregon 97123 (US)**

(74) Representative: **Baillie, Iain Cameron et al**
**c/o Ladas & Parry Isartorplatz 5**
**D-8000 München 2 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

**Description**

This invention relates to the detection of improper operation of a digital data processing apparatus.

It is desirable that a fault condition occurring in a digital data processing apparatus be detected promptly. Furthermore, it is desirable that the detection of a fault condition should be accomplished during operation of the apparatus, without its being necessary to stop operation in order to detect a fault condition.

US—A—2945915 discloses a method of testing the operability of a data processing system by feeding a test message into the data processing system and then comparing the output of the data processing system with a reference signal. Any improper operation of the system results in a miscomparison that generates an error indication. In this reference it is required that periods of no data or non operation be provided to perform a test, compared analogue voltages and infers switching to a redundant system if an error is present. The reference can, furthermore, not be applied to a television video signal where it is required to sync an input composite video signal to a reference video signal. The present invention seeks to overcome the foregoing disadvantages.

According to one aspect of this invention there is provided a method of detecting improper operation of a digital data processing apparatus, comprising applying a predetermined pattern of data digits to a data input of the apparatus and determining whether the pattern of digits provided at a data output of the apparatus in response to the application of said predetermined pattern of digits corresponds to a reference pattern indicating proper operation, said method being characterised by providing n parallel data paths with each data digit having m possible states, said predetermined pattern of digits comprising p successive subpatterns of n digits each, the p successive subpatterns being applied to the n parallel paths and each digit of the subpattern having m possible states.

According to another aspect of this invention there is provided an apparatus for detecting improper operation of a digital data processing means having a data input and a data output, the apparatus having a first circuit for applying a predetermined pattern of data digits to said data input and a second circuit for detecting whether the corresponding pattern of data digits provided at the output of the apparatus corresponds to a reference pattern indicating proper operation, said apparatus being characterised by having n parallel data paths with each data digit having m possible states, said first circuit applying p successive subpatterns of n digits each to said n parallel data paths, each digit of the subpatterns having m possible states.

Thus the present invention permits a digital data processing apparatus to be tested during operation of the apparatus by inserting a test pattern into an operational data sequence and extracting the test pattern later to restore the data sequence. The invention also operates entirely in the digital domain and allows the apparatus to be used even in the presence of errors by compensating for the errors and does not switch to a redundant system as in the above prior art.

The present invention may be used to detect a fault condition in a digital video signal processing apparatus including a large memory, such as a frame or multi-frame store, located between the point of analog-to-digital conversion and the point of digital-to-analog conversion. In a preferred embodiment of the invention, a fault condition which is identified as a memory bit error is at least partially concealed by shifting the data digits entering and leaving the memory such that the faulty memory device is in the path of the least significant data digit.

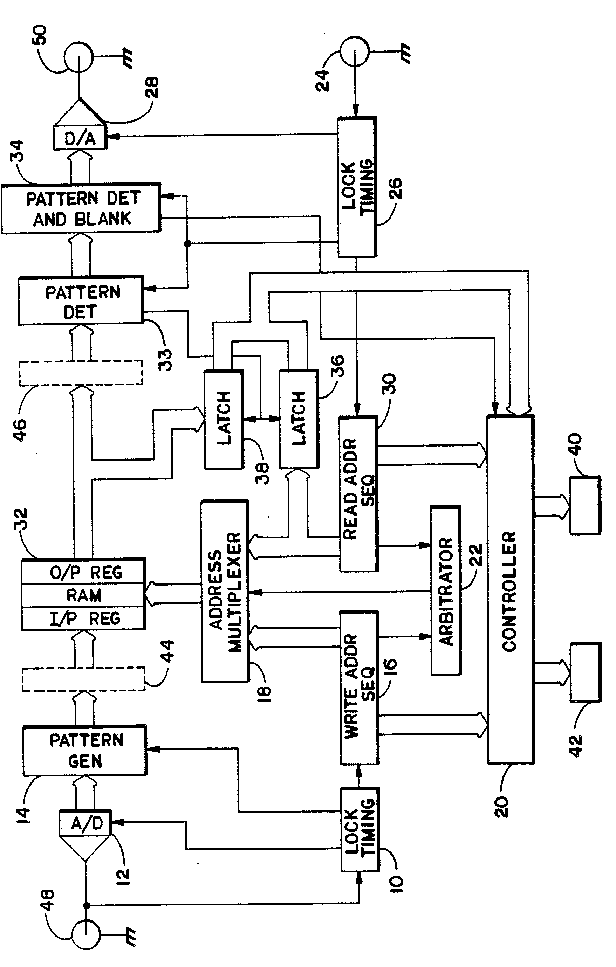

For a better understanding of the invention, and to show how the same may be carried into effect, reference will now be made, by way of example, to the accompanying drawing, the single figure of which is a block diagram of a television frame synchronizer.

The illustrated frame synchronizer receives a composite video input signal, including sync pulses and video information. The video information may include a color subcarrier. The frame synchronizer encodes the input signal into digital form and temporarily stores the digital data in a memory array. The digital data is read out of the memory array and decoded into analog form, under control of a reference signal including sync pulses and a subcarrier wave, thereby to generate from the input signal a corresponding composite video output signal in which the sync pulses and the color subcarrier (if present in the video information of the input signal) are in predetermined phase relationship to the sync pulses and subcarrier wave of the reference signal.

The composite video input signal is applied to a video signal input terminal 48 which is connected to a write lock and timing circuit 10 and to an analog-to-digital converter 12, preferably a ten-bit analog-to-digital converter. The lock and timing circuit 10 generates a continuous waveform at the color subcarrier frequency and synchronized with the color burst signal of the composite video input signal. This continuous waveform is used to generate clock pulses at a repetition rate equal to a multiple of, for example 4 times, the subcarrier frequency, and these clock pulses establish the sampling times of the converter 12. Thus, at each clock pulse the A/D converter 12 generates a 10 bit data word representing in binary code the voltage level of the signal present at the video signal input terminal on occurrence of the clock pulse. The clock pulses from the lock and timing circuit 10 are additionally supplied to a write address sequencer 16. In response to the clock pulses, the write address sequencer 16 generates a predetermined sequence of address words which are supplied both to an address multiplexer 18 and to a controller 20. While an address word is being applied by the write address sequencer 16 to the address multiplexer 16 and to the controller 20, a memory access request signal is applied to an arbitrator 22.

The reference input signal is applied to a reference input terminal 24 which is connected to a read lock and timing circuit 26. The read lock and timing circuit 26 operates in similar fashion to the write lock and timing circuit 10, in that it generates a continuous wave at the reference subcarrier frequency and produces therefrom a train of clock pulses at the same multiple of the reference subcarrier frequency as that relating the frequency of the clock pulses generated by the circuit 10 to the input video signal subcarrier frequency. The clock pulses are applied to a ten-bit digital-to-analog converter 28 to establish conversion times for the converter. The clock pulses are also applied to a read address sequencer 30 to generate the same predetermined sequence of address words as is generated by the sequencer 16 and apply the sequence of address words to the address multiplexer 18 and to the controller 20. While an address word is being applied by the read address sequencer 30 to the address multiplexer 18 and to the controller 20, a memory access request signal is applied to the arbitrator 22.

The output bus of the A/D converter 12 is connected through a pattern generator 14 to the internal data bus of a memory array 32. The internal data bus of the memory array 32 is also connected through a pattern detector 33 and a pattern detector and blanking circuit 34 to the input bus of the D/A converter 28. The address bus of the memory array is connected to the address multiplexer 18. As will be apparent from the foregoing, the data words received from the A/D converter 12 in synchronism with the clock pulses generated by the timing circuit 10 are written into the memory array 32 utilizing the memory locations defined by the address words provided to the memory array by the sequencer 16, and the data words are read out of the memory array 32, from the locations defined by the address words provided by the sequencer 30, in synchronism with the clock pulses generated by the timing circuit 26. The output data words are applied to the D/A converter 28, which operates under control of the clock pulses generated by the timing circuit 26 to reconstruct the digital data into the composite video output signal, which is provided at a video signal output terminal 50 and in which the sync pulses and the subcarrier are in phase with the sync pulses and subcarrier of the reference signal.

There is no definite phase relation between the clock pulses generated by the timing circuit 26 and those generated by the timing circuit 10. Therefore, in order to avoid contentions between the read and write demands imposed upon the memory array, the memory array includes not only random access memories (the storage elements proper) but also input data registers, for temporarily storing input data words until access can be had to the RAMs, and output data registers, for temporarily storing output data words from the RAMs until access can be had to the memory's internal data bus. In addition, the address word provided by the sequencer 16 or 30 is maintained at the output of the respective sequencer until that sequencer is called upon, by the lock and timing circuit 10 or 26, to provide the next address word. This interval is long enough to insure that if, for example, a write access is being performed when the read address sequencer 30 receives a clock signal and generates the next address word in its sequence, and thus calls for a read access, there is sufficient time to complete the write access before the said next address word is removed from the output of the sequencer 30. The arbitrator 22 utilizes the memory access request signals to control the accessing of the memory so as to resolve conflicts between the demands placed on the RAMs.

It will be noted that the write address sequencer 30 is also connected to the controller 20. The purpose of this connection is to provide to the controller the address of the memory location at which the data word representing a selected point of each frame of the input video signal, e.g., the leading edge of sync on line 1, is stored. The read address sequencer identifies the corresponding point of the reference video signal, and the controller provides the address of the relevant data word to the read address sequencer. The read address sequencer uses the address of this selected reference point as the starting point for reading data words from the memory 32, and it is in this manner that the desired synchronisation is accomplished.

In addition to the components whose functions have already described, the frame synchronizer comprises the pattern generator 14 interposed between the A/D converter 12 and the memory array 32, and the pattern detector 33 and the pattern detector and blanking circuit 34 interposed between the memory array 32 and the D/A converter 28. The timing circuit 10, as well as generating the clock pulses for controlling operation of the A/D converter 12 and the write address sequencer 16, also detects the vertical blanking interval of the input video signal and causes the pattern generator 14 to insert an alternating pattern of test data words 1000000000 and 0111111111 into the stream of video data words passing from the A/D converter to the memory array during an unused line, for example line 9, of the vertical blanking interval of the input signal. The test data words are field correlated, i.e., after each odd-numbered field the word 1000000000, e.g., is inserted and after each even-numbered field the word 0111111111 is inserted. The pattern detector 33 is controlled by the timing circuit 26 to examine the data words read out from the memory during line 9 of the vertical blanking interval of the reference signal. The pattern detector compares the complement of the most significant bit of each test data word received during line 9 of the vertical blanking interval with the remaining data bits of the word.

A non-match indicates a fault condition which results in a signal being generated to cause latches 36 and 38 to store the address word identifying the location in the memory array from which the word was read and the word itself. The address word and the test data word are applied to the controller 20.

The pattern detector and blanking circuit 34 is also controlled by the timing circuit 26 to examine, in similar manner to the pattern detector 33, the data words read out during line 9 of the vertical blanking interval of the reference signal. In the event that a fault is detected, the circuit 34 provides a signal to the controller 20. The circuit 34 also reinserts the blanking level into the stream of words which is passed on to the D/A converter 28.

The total number of memory locations in the memory array is greater than the total number of memory locations required to store an entire frame and is not equal to an integral multiple thereof. The data words applied to the memory array are written into the memory sequentially, using all the memory locations. Accordingly, the selected alternating pattern of words inserted by the pattern generator causes all data lines and all memory locations to be exercised to both allowable states during quite a short period of time.

The controller 20 examines the address and data words received from the latches 36 and 38. If an error is observed in the same bit of numerous data words, an interface fault is indicated. In a practical construction of the frame synchronizer, the memory array 32 and the arbitrator 22 are constructed on a first circuit board, and the pattern detector 33 and the latches 36 and 38 are constructed on a second circuit board with the blocks 16, 18, 20 and 30. The pattern detector 34 and the D/A converter 28 are constructed on yet a third board. If an interface fault is detected by the circuit 33 and a corresponding fault is detected by the circuit 34, an interface fault between the first and second circuit boards or between the memory 32 and the pattern generator 14 is indicated. If an interface fault is detected by the circuit 34 without a corresponding fault being detected by the circuit 33, an interface fault between the second and third boards is indicated. A repeated non-match at the same bit position of a given memory location, with a corresponding error being detected by the circuit 34, indicates a memory fault. Pattern sensitivity errors in memory may also be detected by virtue of the nearly random nature of the video data in memory and of the fact that the test pattern overwrites that data. When the controller has received sufficient information to enable it to diagnose the particular fault giving rise to errors, it causes a visible error message to be displayed by means of LEDs 40. The controller is also provided with switches 42 which enable more specific information regarding the fault condition to be displayed by the LEDs 40.

Unlike many data processing applications, in a digital video signal processing apparatus a fault condition does not always require that the apparatus be taken out of service. Thus, a fault in one bit position of a given memory location, so that the bit read out from the position is always a one or is always a zero, does not normally degrade the composite video output signal to such an extent that the frame synchronizer could not be used. Clearly, however, it is desirable that the effect of the fault condition should be concealed as far as possible. Accordingly, it is preferred that a bit shifter circuit 44, as shown in broken lines in the drawing, should be interposed between the pattern generator 14 and the memory array 32, so that a less significant bit of an input data word is directed to a faulty bit position, and a second bit shifter circuit 46 should be interposed between the memory array 32 and the pattern detector 34 for restoring the bits of output words to their previous positions. The directing of the less significant bit to the faulty bit position may be controlled automatically in response to the error detection.

It will be appreciated that the invention is not restricted to the particular digital data processing apparatus that has been described, since variations may be made therein without departing from the scope of the invention as defined in the appended claims, and equivalents thereof. For example, the invention is not restricted to use with a frame synchronizer, in which the output data from the circuit under test (the memory array) is identical to the input data, but can also be applied to other apparatus in which the output data bears a predetermined relationship to the input data. It is not essential that a plurality of test data words be written consecutively into the circuit under test and read out consecutively from the circuit under test. In certain applications, it may be desirable to write a single test word into the circuit under test, followed by a block of data words, then a second test word followed by a second block of data words, and so on.

Claims

1. A method of detecting improper operation of a digital data processing apparatus, comprising applying a predetermined pattern of data digits to a data input of the apparatus and determining whether the pattern of digits provided at a data output of the apparatus in response to the application of said predetermined pattern of digits corresponds to a reference pattern indicating proper operation, said method being characterized by providing n parallel data paths with each data digit having m possible states, said predetermined pattern of digits comprising p successive subpatterns of n digits each, the p successive subpatterns being applied to the n parallel paths and each digit of the subpattern having m possible states.

2. A method as claimed in claim 1, wherein m is two and one digit of one subpattern has one of the two possible states and each other digit of said one subpattern has the other of the two possible states.

3. A method as claimed in claim 2, wherein the most significant digit of said one subpattern has a unique one of the two possible states and each other digit of said one subpattern has the other of the two possible states, and the pattern of data digits provided at the output of the apparatus in response to application of said predetermined pattern to said input is compared to the pattern that would be provided at said output if the apparatus were working properly by comparing the complement of the most significant digit of each subpattern with the other digits of the subpattern.

4. A method as claimed in any preceding claim, wherein said pattern of data digits is applied to the input of the apparatus by inserting it into a stream of data digits in place of at least one data word of said stream, and said predetermined pattern of data digits is removed from the stream of data words at the output of the apparatus and is replaced in said stream by at least one other data word.

5. An apparatus for detecting improper operation of a digital data processing means (32) having a data input and a data output, the apparatus having a first circuit (14) for applying a predetermined pattern of data digits to said data input and a second circuit (33) for detecting whether the corresponding pattern of data digits provided at the output of the apparatus corresponds to a reference pattern indicating proper operation, said apparatus being characterized by having n parallel data paths with each data digit having m possible states, said first circuit applying p successive subpatterns of n digits each to said n parallel data paths, each digit of the subpatterns having m possible states.

6. An apparatus according to claim 5, wherein said first circuit (14) generates one digit of one subpattern with one of two possible states, m being two, and each other digit of said one subpattern with the other of the two possible states.

7. An apparatus according to claim 6, wherein the first circuit (14) generates the most significant digit of said one subpattern as having the unique one of the two possible states, and the second circuit (33) compares the complement of the most significant digit with each of the other digits of said one subpattern to determine if the apparatus is operating properly.

8. An apparatus according to any of claims 5 to 7, wherein said first circuit (14) has means for inserting into a stream of data words being applied to said data input in place of at least one data word of said stream the predetermined pattern, and wherein the second circuit (33) has means for replacing the corresponding data word of said stream at the data output of the apparatus with at least one predetermined data word.

9. An apparatus according to claim 5, wherein said processing means is a memory array (32).

10. An apparatus according to claim 9 comprising a first digit shifting circuit (44) interposed between said first circuit (14) and said memory array (32); and a second digit shifting circuit (46) interposed between said memory array (32) and said second circuit (33), said first digit shifting circuit (44) shifting the digits of a data word applied to said data input (48) in one direction, and the second digit shifting circuit (46) shifting the digits of the corresponding data word provided at the data output in the opposite direction.

**Patentansprüche**

1. Verfahren zum Erkennen einer Funktionsstörung in einem digitalen Datenverarbeitungsgerät, in dem ein vorherbestimmtes Muster von Datenstellen an einen Dateneingang des Geräts angelegt und festgestellt wird, ob des auf Grund des Anlegens des vorherbestimmten Musters von Stellen en einem Datenausgang des Geräts erhaltene Stellenmuster einem eine einwandfreie Funktion anzeigenden Bezugsmuster entspricht, wobei das Verfahren dadurch gekennzeichnet ist, daß für jede Datenstelle mit m möglichen Zuständen n parallele Datenwege geschaffen werden, daß das vorherbestimmte Stellenmuster p aufeinanderfolgende Teilmuster mit je n Stellen besitzt, daß die p aufeinanderfolgenden Teilmuster an die n parallelen Wege angelegt werden und daß jede Stelle des Teilmusters m mögliche Zustände hat.

2. Verfahren nach Anspruch 1, dadurch gekennzeichnet, daß m gleich zwei ist, daß eine Stelle eines Teilmusters sich in dem einen der zwei möglichen Zustände befindet und daß sich jede andere Stelle des genannten einen Teilmusters in dem anderen der beiden möglichen Zustände befindet.

3. Verfahren nach Anspruch 2, dadurch gekennzeichnet, daß die höchstwertige Stelle des genannten einen Teilmusters sich in einem bestimmten der beiden möglichen Zustände befindet, daß jede andere Stelle des genannten einen Teilmusters sich in dem anderen der beiden möglichen Zustände befindet und daß Muster der Datenstellen, die auf Grund des Anlegens des vorherbestimmten Musters an den genannten Eingang am Ausgang des Geräts erhalten werden mit dem Muster verglichen wird, das an dem Ausgang erhalten werden würde, wenn das Gerät einwandfrei arbeitete, wobei zu diesem Zweck das Komplement der höchstwertigen Stelle jedes Teilmusters mit den anderen Stellen des Teilmusters verglichen wird.

4. Verfahren nach einem der vorhergehenden Ansprüche, dadurch gekennzeichnet, daß zum Anlegen des Musters von Datenstellen an den Eingang des Geräts dieses Muster enstelle mindestens eines Datenwortes eines Stroms von Datenstellen in diesen Strom eingefügt wird und daß am Ausgang des Geräts das vorherbestimmte Muster von Datenstellen aus dem Strom von Datenworten entfernt und in dem Strom durch mindestens ein weiteres Datenwort ersetzt wird.

5. Vorrichtung zum Erkennen einer Funktionsstörung in einem digitalen Datenverarbeitungsgerät (32), das einen Dateneingang und einen Datenausgang besitzt, wobei die Vorrichtung eine erste Schaltung (14) besitzt, die dazu dient, ein vorherbestimmtes Muster von Datenstellen an den Dateneingang enzulegen, sowie eine zweite Schaltung (33), die dazu dient, zu erkennen, ob das am Ausgang des Verarbeitungsgeräts erhaltene, entsprechende Muster von Datenstellen einem Bezugsmuster entspricht, das einen einwandfreien Betrieb anzeigt, wobei die Vorrichtung dadurch gekennzeichnet ist, daß sie n parallele Datenwege besitzt, wobei jede Datenstelle m mögliche Zustände annehmen kann, die erste Schaltung p aufeinanderfolgende Teilmuster von je n Stellen an die n parallelen Datenwege anlegt und jede Stelle der Untermuster m mögliche Zustände annehmen kann.

6. Vorrichtung nach Anspruch 5, dadurch gekennzeichnet, daß die erste Schaltung (14) eine Stelle eines Teilmusters in einem von zwei möglichen Zuständen erzeugt, wobei m gleich zwei ist, und jede andere Stelle des genannten einen Teilmusters in dem anderen der beiden möglichen Zustände erzeugt.

7. Vorrichtung nach Anspruch 6, dadurch gekennzeichnet, daß die erste Schaltung (14) die höchstwertige Stelle des genannten einen Teilmusters in einem bestimmten der beiden möglichen Zustände erzeugt und die zweite Schaltung (33) das Komplement der höchstwertigen Stelle mit jeder der anderen Stellen des genannten einen Teilmusters vergleicht, um festzustellen, ob das Verarbeitungsgerät einwandfrei arbeitet.

8. Vorrichtung nach einem der Ansprüche 5 bis 7, dadurch gekennzeichnet, daß die erste Schaltung (14) Mittel besitzt, die dazu dienen, das vorherbestimmte Muster in einen Strom an den genannten Dateneingang angelegten Strom von Datenworten anstelle mindestens eines Datenwortes dieses Stroms einzufügen, und daß die zweite Schaltung (33) Mittel besitzt, die dazu dienen, am Datenausgang des Verarbeitungsgeräts das entsprechende Datenwort in dem Strom durch mindestens ein vorherbestimmtes Datenwort zu ersetzen.

9. Vorrichtung nach Anspruch 5, dadurch gekennzeichnet, daß das Verarbeitungsgerät eine Speicheranordnung (32) ist.

10. Vorrichtung nach Anspruch 9 mit einer ersten Stellenschiebeschaltung (44), die zwischen der ersten Schaltung (14) und der Speicheranordnung (32) geschaltet ist, und mit einer zweiten Stellenschiebeschaltung (46), die zwischen der Speicheranordnung (32) und der zweiten Schaltung (33) geschaltet ist, wobei die erste Stellenschiebeschaltung (44) die Stellen eines an den Dateneingang (48) angelegten Datenworts in einer Richtung verschiebt und die zweite Stellenschiebeschaltung (46) die Stellen des am Datenausgang erhaltenen, entsprechenden Datenworts in der entgegengesetzten Richtung verschiebt.

**Revendications**

1. Procédé de détection d'un fonctionnement incorrect d'un appareillage de traitement numérique de données, comprenant les étapes consistant à appliquer une combinaison prédéterminée de chiffres de données à une entrée de données de l'appareillage et à déterminer si la combinaison de chiffres obtenue à la sortie de données de l'appareillage en réponse à l'application de la combinaison prédéterminée de chiffres correspond à une combinaison de référence indiquant un functionnement correct, ce procédé étant caractérisé par le fait qu'il est prévu n chemins de données parallèles, chaque chiffre de données ayant m états possibles, la combinaison prédéterminée de chiffres comprenant p sous-combinaisons successives de n chiffres chacune, les p sous-combinaisons successives étant appliquées aux n chemins parallèles et chaque chiffre de la sous-combinaison ayant m états possibles.

2. Procédé selon la revendication 1, caractérisé en ce que m est égal à deux et qu'un chiffre d'une sous-combinaison a un de deux états possibles et que l'autre chiffre de la sous-combinaison a l'autre des deux états possibles.

3. Procédé selon la revendication 2, caractérisé en ce que le chiffre de plus fort poids de ladite sous-combinaison a un seul des deux états possibles et que chaque autre chiffre cette sous-combinaison a l'autre des deux états possibles, et que la combinaison de chiffres de données obtenue à la sortie de l'appareillage en réponse à l'application de ladite combinaison prédéterminée à ladite entrée est comparée à la combinaison qui serait obtenue à cette sortie si l'appareillage fonctionnait correctement, en comparant le complément du chiffre de plus fort poids de chaque sous-combinaison aux autres chiffres de la sous-combinaison.

4. Procédé selon l'une des revendications précédentes, caractérisé en ce que la combinaison de chiffres de données est appliquée à l'entrée de l'appareillage en l'insérant dans un flux de chiffres de données à la piece d'au moins un mot de données de ce flux, et que la combinaison prédéterminée de chiffres de données est enlevée du flux de mots de données à la sortie de l'appareillage et est remplacée dans ce flux par au moins un autre mot de données.

5. Appareillage pour détecter un fonctionnement incorrect de moyens de traitement numérique de données (32) ayant une entrée de données et une sortie de données, l'appareillage ayant un premier circuit (14) pour appliquer une combinaison prédéterminée de chiffres de données à l'entrée de données (48), et un deuxième circuit (33) pour détecter si la combinaison correspondante de chiffres de données obtenue à la sortie (50) de l'appareillage correspond à une combinaison de référence indiquant un fonctionnement correct, cet appareillage étant caractérisé par le fait qu'il a n chemins de données parallèles, chaque chiffre de donnée ayant m états possibles, le premier circuit (14) appliquant p sous-combinaisons successives de n chiffres chacune aux n chemins de données parallèles, et chaque chiffre des sous-combinaisons ayant m états possibles.

6. Appareillage selon la revendication 5, caractérisé en ce que le premier circuit (14) produit un chiffre d'une sous-combinaison avec un de deux états possibles, m étant égal à deux, et chaque autre chiffre de la sous-combinaison avec l'autre des deux états possibles.

7. Appareillage selon la revendication 6, caractérisé en ce que le premier circuit (14) produit le chiffre de plus fort poids de ladite sous-combinaison comme ayant ledit seul état des deux états possibles, et que le deuxième circuit (33) compare le complément du chiffre de plus fort poids à chacun des autres chiffres de cette sous-combinaison pour déterminer si l'appareillage fonctionne correctement.

8. Appareillage selon l'une des revendications 5 à 7, caractérisé en ce que le premier circuit (14) a des moyens pour insérer dans un flux de mots de données appliqué à l'entrée de données (48), à la place d'au moins un mot de données de ce flux, la combinaison prédéterminée, et que le deuxième circuit (33) a des moyens pour remplacer le mot de données correspondant de ce flux à la sortie de données de l'appareillage par au moins un mot de données prédéterminé.

9. Appareillage selon la revendication 5, caractérisé en ce que lesdits moyens de traitement sont un groupement de mémoires (32).

10. Appareillage selon la revendication 9, caractérisé en ce qu'il comporte un premier circuit de décalage de chiffres (44) interposé entre le premier circuit (14) et le groupement de mémoires (32), et un deuxième circuit de décalage de chiffres (46) interposé entre le groupement de mémoires (32) et le deuxième circuit (33), le premier circuit de décalage de chiffres (44) décalant les chiffres d'un mot de donnée appliqué à l'entrée de données (48) dans un sens, et le deuxième circuit de décalage de chiffres (46) décalant les chiffres du mot de donnée correspondant obtenu à la sortie des données dans le sens opposé.

PATTERN DET AND BLANK

D/A

LOCK TIMING

PATTERN DET

LATCH

LATCH

READ ADDR SEQ

O/P REG
RAM
I/P REG

ADDRESS MULTIPLEXER

ARBITRATOR

CONTROLLER

PATTERN GEN

WRITE ADDR SEQ

A/D

LOCK TIMING